# EUROPÄISCHE PATENTSCHRIFT

(11) **EP 1 277 382 B1**
(45) Veröffentlichungstag und Bekanntmachung des Hinweises auf die Patenterteilung: **24.01.2007**
(21) Anmeldenummer: 01942985.1
(22) Anmeldetag: 26.04.2001
(51) Int. Cl.: H05K 13/04

(54) **ZUFÜHREINRICHTUNG FÜR IN EINEM GURT AUFGENOMMENE ELEKTRISCHE BAUTEILE**
FEEDER FOR ELECTRIC COMPOUNDS WHICH ARE TAKEN UP IN A BELT
DISPOSITIF D'ALIMENTATION POUR COMPOSANTS ELECTRIQUES PLACES DANS UNE COURROIE

(30) Priorität: 27.04.2000 DE 10020748
(43) Veröffentlichungstag der Anmeldung: 22.01.2003
(73) Patentinhaber: Siemens AG, 80333 München (DE)
(72) Erfinder: LIEBEKE, Thomas, 85521 Ottobrunn (DE)
(86) Internationale Anmeldenummer: PCT/DE2001/001616
(87) Internationale Veröffentlichungsnummer: WO 2001/082673

(56) Entgegenhaltungen:
- EP-A- 0 589 275
- FR-A- 2 546 024
- US-A- 4 440 355

## Beschreibung

Die Erfindung bezieht sich auf eine Zuführeinrichtung für in zumindest einem Gurt aufgenommene elektrische Bauteile, wobei der Gurt mittels eines Transportrades antreibbar ist.

Durch die EP 0 589 275 A1 ist eine Zuführeinrichtung bekannt geworden, nach der das Transportrad zahnradartig mit Transportstiften versehen ist, die in Transportlöcher des Gurtes eingreifen und die im Gurt aufgenommenen Bauteile schrittweise in eine Abholposition transportieren. Dabei wird der Abholort für das Bauteil durch die Lage des Transportstiftes bestimmt. Das bedeutet, daß die Lage des dem Abholort benachbarten Transportstiftes genau festgelegt sein muß, um auch miniaturisierte Bauteile sicher entnehmen zu können.

Es ist bisher üblich, das Transportrad auf einer Welle zu befestigen, die in einem Gehäuse der Zuführeinrichtung drehgelagert ist. Um die Seitenlage des Transportstiftes genau einzustellen, waren besondere Justagemaßnahmen erforderlich. Beispielsweise wurde die spielfreie Seitenlage des Transportrades mit Hilfe von Distanzscheiben eingestellt, was mit erheblichem Montageaufwand verbunden ist.

Durch die Siemens-Firmenschrift 0 299-S-23-500-d, Ausgabe 1, Seite 12, ist zum Beispiel eine Zuführeinrichtung bekannt geworden, in der zwei Gurte aufgenommen sind. Hierbei ist es besonders schwierig, die beiden Transporträder mit ihren Wellen so zu justieren, daß auch ihre relative Lage zueinander genau festgelegt ist.

Der Erfindung liegt die Aufgabe zugrunde, den Montageaufwand und insbesondere den Justieraufwand zu verringern.

Diese Aufgabe wird durch die Erfindung gemäß Anspruch 1 gelöst. Durch die Anordnung des Lagers auf der feststehenden Achse und deren Fixierung an der Anschlagfläche des Gehäuses ist es möglich, den Justiervorgang vor dem Einbau, also außerhalb des Gehäuses, vorzunehmen. Dabei kann der gewünschte Abstand zwischen den Transportstiften und der Stirnseite der Achse durch axiales Verschieben des Lagers, zum Beispiel mit Hilfe einer lehrenartigen Montagevorrichtung, genau auf das gewünschte Maß eingestellt werden. Besonders vorteilhaft ist es dabei, daß hier nur ein Lager benötigt wird, dessen relativ großer Wälzdurchmesser und dessen Spielfreiheit eine stabile Winkellage ermöglichen.

Vorteilhafte Weiterbildungen der Erfindung sind in den Unteransprüchen gekennzeichnet:
Durch das Verkleben nach Anspruch 2 kann das Lager auf der Achse beim Justieren leichtgängig und damit feinstufig verschoben werden. Nach dem Aushärten des Klebers ermöglicht die stoffschlüssige Verbindung eine sichere Fixierung, so daß die so geschaffene Baugruppe nach Anspruch 3 problemlos in das Gehäuse der Zuführeinrichtung eingebaut werden kann.
Durch die Weiterbildung nach Anspruch 4 werden die beiden Lagerringe mit großer Genauigkeit spielfrei geführt.
Durch die Weiterbildung nach Anspruch 5 ist es möglich, mehrere Transporträder gleichzeitig zu justieren und zu fixieren und in einer Montageeinheit zusammenzufassen, so daß sich der Gesamtaufwand nur unwesentlich erhöht.

Im folgenden wird die Erfindung anhand eines in der Zeichnung dargestellten Ausführungsbeispiels näher erläutert.
Figur 1 zeigt schematisiert einen Teil eines Zuführmoduls in einer Seitenansicht,
Figur 2 einen Teilschnitt durch das Zuführmodul nach Figur 1.

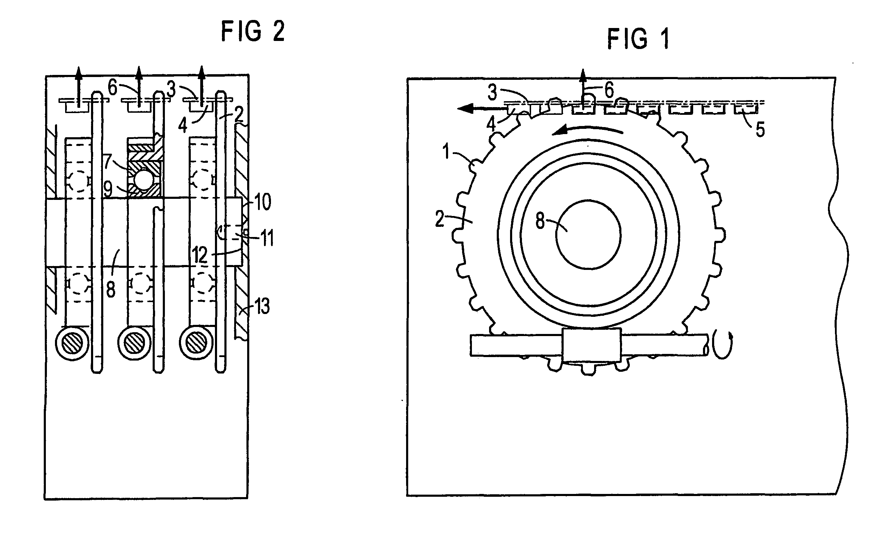

Nach den Figuren 1 und 2 greifen Transportstifte 1 eines schneckengetriebenen Transportrades 2 zahnartig in Transportlöcher eines Gurtes 3 ein, der mit Taschen 4 zur Aufnahme von elektrischen Bauteilen 5 versehen ist. Durch schrittweises Weiterdrehen des Transportrades werden die Taschen 5 sukzessive in eine Abholposition 6 transportiert, wo sie zum Beispiel mittels eines Sauggreifers einer Bestückeinrichtung für Leiterplatten aus dem Gurt 3 entnommen werden können. Die Abholposition ist durch definierte Zuordnung der Tasche 4 zum Transportloch bestimmt, in das der Transportstift 1 spielfrei eingreift.

Die Zuführeinrichtung weist drei Transporträder 2 für drei zueinander parallele Gurte 3 auf. Die Transporträder 2 sind über Kugellager auf einer gemeinsamen Achse 8 gelagert. Innenringe 9 der Kugellager 7 sind mittels eines aushärtenden Klebers auf der Achse 8 fixiert. Diese ist mit einer ihren Stirnseiten 10 mittels einer Schraube 11 gegen eine definierte Anschlagfläche 12 eines Gehäuses 13 der Zuführeinrichtung gespannt.

Die Transporträder 2 sind vor dem Einbau in das Gehäuse 13 in einer lehrenartigen Montagevorrichtung mit der Achse verklebt worden, so daß sie definierte Abstände zur Stirnseite 10 und damit eine genaue Seitenposition einnehmen. Beim Einbau dieser Baugruppe in das Gehäuse 13 kann auf weitere Justiermaßnahmen völlig verzichtet werden. Die Lagerringe des Kugellagers 7 sind mit V-Nuten für die unter Vorspannung eingesetzten Kugeln versehen. Dadurch können die Transporträder mit hoher Lagegenauigkeit spielfrei gelagert werden.

## Patentansprüche

1. Zuführeinrichtung für in zumindest einem Gurt (3) aufgenommene elektrische Bauteile (5),
wobei der Gurt (3) mittels eines Transportrades (2) antreibbar ist,
**dadurch gekennzeichnet,**
**daß** das Transportrad (2) mittels eines Wälzlagers (z.B. 7) auf einer feststehenden Achse (8) spielfrei gelagert ist, die in einem Gehäuse (13) der Zuführeinrichtung verankert ist, daß die Achse (8) mit einer Stirnseite (10) gegen eine definierte Anschlagfläche (11) des Gehäuses (13) gespannt ist daß das Transportrad (2) vor dem Einbau in das Gehäuse (13) in der Achsrichtung in einem definierten Abstand zur Stirnseite (10) auf der Achse (8) fixiert ist.

2. Zuführeinrichtung nach Anspruch 1,
**dadurch gekennzeichnet,**
**daß** ein Innenring (9) des Wälzlagers auf der Achse durch Verkleben fixiert ist.

3. Zuführeinrichtung nach Anspruch 2,
**dadurch gekennzeichnet,**
**daß** das Wälzlager (z.. 7) vor dem Verkleben mit der Achse (8) in das Transportrad (2) eingesetzt ist.

4. Zuführeinrichtung nach Anspruch 2 oder 3,
**dadurch gekennzeichnet,**
**daß** das Wälzlager (z.B. 7) als Kugellager (7) ausgebildet ist,
**daß** der Innenring (9) und ein Außenring des Kugellagers (7) mit jeweils einer V-Nut versehen sind und
**daß** Wälzkugeln des Kugellagers (7) in den beiden V-Nuten unter elastischer Vorspannung spielfrei geführt sind.

5. Zuführeinrichtung nach einem der Anspruch 1 bis 4,
**dadurch gekennzeichnet,**
**daß** auf der Achse (8) mehrere Transporträder (2) für mehrere Gurte (3) in definierten Abständen zur Stirnseite (10) der Achse (8) fixiert sind.

## Claims

1. Feeding device for electric components (5) accommodated in at least one belt (3)
with the belt (3) being able to be driven by means of a conveying wheel (2),
**characterised in that**
the conveying wheel (2) is mounted on a fixed axis (8) in a play-free manner by means of a roller bearing (e.g. 7), said axis (8) being anchored in a housing (13) of the feeding device, such that a front side (10) of the axis (8) is tensioned against a defined stop surface (11) of the housing (13) and prior to incorporation into the housing (13) the conveying wheel (2) is fixed to the axis (8) in the axial direction at a defined distance from the front side (1).

2. Feeding device according to claim 1,
**characterised in that**
an inner ring (9) of the roller bearing is fixed to the axis by means of adhesion.

3. Feeding device according to claim 2,
**characterised in that**
the roller bearing (e.g. 7) is inserted into the conveying wheel (2)prior to adhesion to the axis (8).

4. Feeding device according to claim 2 or 3,
**characterised in that**
the roller bearing (e.g. 7) is designed as a ball-bearing (7), the inner ring (9) and an outer ring of the ball-bearing (7) are provided with a V-groove in each instance and
roller balls of the ball-bearing (7) are guided in the two V-grooves in a play-free manner using elastic pre-tensioning.

5. Feeding device according to one of claims 1 to 4,
**characterised in that**
several conveying wheels (2) for several belts (3) are fixed on the axis (8) at defined distances from the front side (10) of the axis (8).

## Revendications

1. Dispositif d'amenée de composants électriques (5) repris dans au moins une bande (3),
dans lequel la bande (3) peut être entraînée par une roue de transport (2),
**caractérisé en ce que**
au moyen d'un palier de roulement (par exemple 7), la roue de transport (2) est montée sans jeu sur un axe fixe (8) qui est ancré dans un boîtier (13) du dispositif d'amenée,
**en ce que** l'axe (8) est serré par un côté frontal (10) contre une surface de butée définie (11) du boîtier (13) et
**en ce que** la roue de transport (2) est fixée sur l'axe (8) à une distance définie par rapport au côté frontal (10) dans la direction de l'axe, avant d'être montée dans le boîtier (13).

2. Dispositif d'amenée selon la revendication 1, **caractérisé en ce qu'**une bague intérieure (9) du palier de roulement est fixée sur l'axe par collage.

3. Dispositif d'amenée selon la revendication 2, **caractérisé en ce que** le palier de roulement (par exemple 7) est inséré dans la roue de transport (2) avant d'être collé sur l'axe (8).

4. Dispositif d'amenée selon la revendication 2 ou 3, **caractérisé en ce que** le palier de roulement (par exemple 7) est configuré comme palier à billes (7), **en ce que** la bague intérieure (9) et une bague extérieure du palier à billes (7) sont respectivement dotées d'une rainure en V et **en ce que** les billes de roulement du palier à billes (7) sont guidées sans jeu et sous précontrainte élastique dans les deux rainures en V.

5. Dispositif d'amenée selon l'une des revendications 1 à 4, **caractérisé en ce que** plusieurs roues de transport (2) pour plusieurs bandes (3) sont fixées sur l'axe (8) à des distances définies par rapport au côté frontal (10) de l'axe (8).
